# EUROPEAN PATENT APPLICATION

(11) **EP 3 536 553 A1**
(43) Date of publication of application: **11.09.2019**
(21) Application number: 18196052.7
(22) Date of filing: 21.09.2018
(51) Int. Cl.: B60Q 1/14, B62J 6/02, B62J 6/06, B60R 16/023, B60R 16/033, B62J 6/00, B62J 6/04

(54) **VEHICLE POWER SUPPLY, VEHICLE LIGHTING SYSTEM AND METHOD FOR SUPPLYING POWER FOR A VEHICLE LIGHTING SYSTEM**

(30) Priority: 09.03.2018 CN 201810196641; 09.03.2018 CN 201820331046 U
(71) Applicant: Beijing Hanergy Solar Power Investment Co., Ltd., Beijing 101499 (CN)
(72) Inventor: WANG, Xing, Beijing, Beijing 101499 (CN)
(74) Representative: Modiano, Gabriella Diana

(57) **Abstract**

A vehicle power supply (10), a vehicle lighting system and a method for supplying power for a vehicle lighting system are provided. The vehicle power supply (10) includes: a power supplying module (102) and a control module (104) coupled to the power supplying module (102); the power supplying module (102) includes a solar module (1021), a battery charging control unit (1022), a battery (1023) and a constant current source (1024), which are coupled in turn. In the control module (104), light intensity of an environment where a vehicle is used is detected through a light intensity detection unit (1041), and vibration of the vehicle is detected through a vibration detection unit (1043). A processing unit determines whether to permit the power supplying module (102) to supply power for a light-emitting device (12) at least based on a relationship between the light intensity and a first threshold and a relationship between the vibration and a second threshold.

## Description

### Technical Field

The present application relates to solar lighting field, in particular to a vehicle power supply, a vehicle lighting system and a method for supplying power for a vehicle lighting system.

### Background

At present, the power supplying mechanism for a vehicle lamp, especially the lamp of a non-motor vehicle (e.g., a bicycle), typically includes two types. One is supplying power by battery, and the other is supplying power by friction power generation, that is, supplying power usually by the friction power generation by a friction generator or converting the kinetic energy of wheel rotation into electric energy by a hub. When powered by a battery, the vehicle lamp powered by a dry battery has a high usage cost since the dry battery needs to be replaced frequently. When the vehicle lamp is powered by a rechargeable battery, it is inconvenient in usage since the rechargeable battery needs to be charged frequently. Although power supplying by the friction power generation may avoid these problems, the vehicle lamp powered by the friction power generation consumes the kinetic energy of the non-motor vehicle, increasing travel resistance, and causing a poor user experience in usage. In addition, when the vehicle lamp powered by the friction power generation works, the friction generator further causes the abrasion of the tire when generating power through friction with the tire. Moreover, generally, the vehicle lamp powered by the friction power generation is powered directly by a friction generator or hub, thus the power supply to the vehicle lamp is not stable. Further, the vehicle lamp powered by the friction power generation usually can only be turned on or off manually, which is not intelligent enough in usage.

### Summary

Embodiments of the present application provide a vehicle power supply, a vehicle lighting system and a method for supplying power for a vehicle lighting system. In one aspect, a vehicle power supply is provided. The vehicle power supply includes:
a power supplying module including a solar module, a battery charging control unit, a battery and a constant current source, which are coupled in turn; and
a control module coupled to the power supplying module, including:
   a light intensity detection unit, configured to detect light intensity of an environment where a vehicle is used;
   a vibration detection unit, configured to detect vibration of the vehicle; and
   a processing unit, configured to determine whether to permit the power supplying module to supply power for a light-emitting device at least based on a relationship between the light intensity detected by the light intensity detection unit and a first threshold and a relationship between the vibration detected by the vibration detection unit and a second threshold.

In another aspect, a vehicle lighting system is provided. The vehicle lighting system includes:
a light-emitting device; and
the vehicle power supply coupled to the light-emitting device.

In yet another aspect, a method for supplying power is further provided, which is used to supply power for a vehicle lighting system. The method includes:
converting solar energy into electric energy by using a solar module, and storing the electric energy into a battery;
detecting light intensity of an environment where a vehicle is used;
detecting vibration of the vehicle;
determining whether to supply power for a light-emitting device at least based on a relationship between the light intensity and a first threshold and a relationship between the vibration and a second threshold.

A better understanding of the nature and advantages of embodiments of the application may be gained with reference to the following detailed description and the accompanying drawings.

### Brief Description of Drawings

Embodiments of the present application will be described in detail in combination with the accompanying drawings, in which:
FIG. 1 is a schematic block diagram of a vehicle lighting system according to an embodiment of the present application.
FIG. 2 is a schematic diagram of a part of a vehicle including a lighting system according to an embodiment of the present application.
FIG. 3 is a flowchart of a method for supplying power according to an embodiment of the present application.
FIG. 4 is a flowchart of a method for supplying power according to another embodiment of the present application.

### Detailed Description

To make objects, schemes and advantages of embodiments of the present application more clear, schemes of embodiments of the present application will be described clearly and completely below in combination with accompanying drawings of embodiments of the present application. It is apparent that the described embodiments are part of embodiments of the present application, rather than all the embodiments. All other embodiments, which are obtained by those of ordinary skill in the art based on the embodiments of the present application without doing inventive work, all fall into the protection scope of the present application.

In the detailed description below, the accompanying drawings, as a part of the present application, may be referred to illustrate the specific embodiments of the present application. In the drawings, similar reference numerals describe substantially similar components in different drawings. Various specific embodiments of the present application are described in sufficient detail below, so that the scheme of the present application can be implemented by those of ordinary skill with related knowledge and technology in the art. It should be understood that other embodiments may be utilized, or structural, logical, or electrical changes may be made to embodiments of the present application.

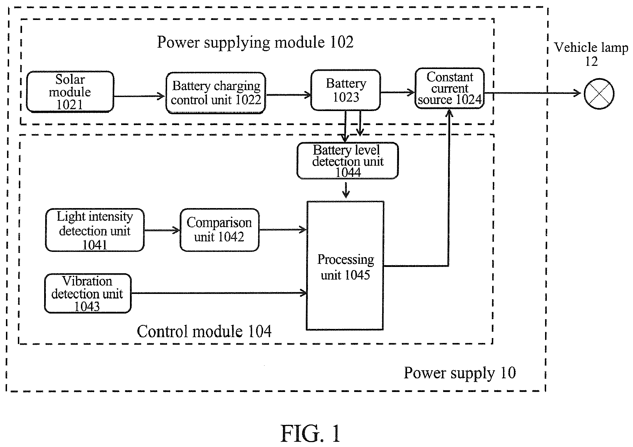

FIG. 1 is a schematic block diagram of a vehicle lighting system according to an embodiment of the present application. The lighting system may include a vehicle power supply 10 and a light-emitting device 12. The vehicle power supply 10 may include a power supplying module 102 and a control module 104. It should be noted that in embodiments of the present application, a vehicle lamp is used as an example of the light-emitting device 12 for illustration.

In an exemplary embodiment, optionally, the power supplying module 102 may include a solar module 1021, a battery charging control unit 1022 coupled to an output end of the solar module 1021, a battery 1023 coupled to an output end of the battery charging control unit 1022, and a constant current source 1024 coupled to the battery 1023.

The solar module 1021 may be of a material type such as crystalline silicon, amorphous silicon, copper indium gallium selenide, gallium arsenide, or the like. The solar module 1021 may be mounted at a position where sunlight is received easily, for example, a basket or body of the vehicle. Herein, for example, the solar module 1021 may be a thin-film solar module, and the advantages of using thin-film solar module may include that the thin-film solar module has a good flexibility and may be more widely applied to various non-motor vehicles. Moreover, the thin-film solar module has a better lighting performance than other solar modules in a relatively weak lighting condition.

The battery charging control unit 1022 may include a lithium battery integrated circuit and a peripheral circuit of the integrated circuit , responsible for storing electric energy output by the solar module 1021 into the battery 1023.

The constant current source 1024 may output a constant current matched with the load vehicle lamp 12 based on the voltage provided by the battery 1023, which ensures that the brightness of the vehicle lamp 12 keeps unchanged with changes of a factor(s), such as temperature, duration of usage or the like.

In an embodiment of the present application, the control module 104 controls a working state of the power supplying module 102. Optionally, the control module 104 determines whether to permit the constant current source 1024 to supply power for the vehicle lamp 12.

The control module 104 may include a light intensity detection unit 1041 and a vibration detection unit 1043, which are respectively coupled to a processing unit 1045.

The light intensity detection unit 1041 is configured to detect light intensity of an environment where a vehicle is used, and output detected light intensity to the processing unit 1045. For example, the light intensity detection unit 1041 may include a photosensitive diode and a peripheral circuit used in combination with the photosensitive diode.

The processing unit 1045 may pre-store a first threshold and a second threshold, for example, the first threshold may be 15lux. The processing unit 1045 is configured to determine whether to permit the power supplying module to supply power for the light-emitting device at least based on a relationship between the light intensity and the first threshold and a relationship between the vibration and the second threshold. Herein, the vibration usually may include vibration amplitude, vibration frequency, vibration period and vibration phase, etc. For example, when the light intensity is less than the first threshold, it is considered that the vehicle is in a weak light condition, and needs to be supplied with power.

In an exemplary embodiment, optionally, the control module 104 may further include a comparison unit 1042. Optionally, a light intensity signal output by the light intensity detection unit 1041 is an analog signal, and the comparison unit 1042 may be used to convert the analog signal into a digital electric signal, and compare the digital electric signal with the first threshold, and then determine whether the vehicle is in a weak light condition.

The vibration detection unit 1043 is configured to detect vibration of the vehicle and output the vibration to the processing unit 1045. When the processing unit 1045 determines that the vibration is greater than the second threshold, the system considers that the vehicle is in a use state. It should be noted that the vibration of the vehicle is usually a mechanical signal, so the vibration detection unit 1043 may adopt a vibration sensor and a periphery circuit used in combination with vibration sensor to convert the mechanical signal into an electric signal.

Since the non-motor vehicle is driven by a user, it is determined whether the vehicle is in the use state, but a state of a non-motor vehicle cannot be determined as a motor vehicle does by determining whether an engine is started or power is on. Usually a state of a non-motor vehicle is determined by determining whether the non-motor vehicle is unlocked, however in many situations, though the non-motor vehicle is not locked, the non-motor vehicle is not in the use state. Therefore, a mechanism of determining the use state through the lock state of the vehicle is inaccurate. In the present application, considering that a non-motor vehicle in the use state will inevitably undergo bumpiness during movement, it is more accurate to determine the use state of the non-motor vehicle by using the vibration detection unit 1043. It should be noted that the manner of determining the use state by using the vibration detection unit 1043 is also suitable for a motor vehicle.

In an exemplary embodiment, the processing unit 1045 receives detection results of the vibration detection unit 1043 and the light intensity detection unit 1041, and obtains a relationship between a detection result of the vibration detection unit 1043 and its corresponding preset threshold, and a relationship between a detection result of the light intensity detection unit 1041 and its corresponding preset threshold. Then the processing unit 1045 permits the power supplying module 102 to supply power for the vehicle lamp 12 when determining that the vehicle is in the use state and in a weak light environment based on comparison results.

In an exemplary embodiment, the control module 104 may further include a battery level detection unit 1044 configured to detect the level of the battery 1023.

The processing unit 1045 is further configured to determine whether to permit the power supplying module 102 to supply power for the light-emitting device (the vehicle lamp 12) at least based on a relationship between the level of the battery and a third threshold, a relationship between the light intensity and the first threshold, and a relationship between the vibration and the second threshold. Optionally, when the output of the battery level detection unit 1044 is an analog signal, the control module 104 may further include a comparison unit 1042, configured to convert the analog signal into a digital electric signal, and compare the digital electric signal with the preset threshold. The processing unit 1045 determines whether the level of the battery is high based on the light intensity, the vibration of the vehicle and the relationship between the level of the battery and its corresponding threshold, thereby further determining whether to supply power to turn on or turn off the vehicle lamp 12. Optionally, the processing unit 1045 is further configured to determine a light-emitting mode of the light-emitting device 12 according to a relationship between the level of the battery and a fourth threshold. In addition, the battery 1023 is further coupled to the control module 104 for supplying power for the control module 104.

The light-emitting mode includes a continuous light-emitting mode and a flickering light-emitting mode.

In an exemplary embodiment, the vehicle power supply 10 may further include a charging module (not shown) coupled to the battery 1023. The charging module includes a discharging control unit and an I/O interface (for example, a USB interface) coupled to the discharging control unit. The discharging control unit is further coupled to the processing unit 1045. When the level of the battery is greater than the third threshold, the processing unit 1045 permits the battery 1023 to supply power for an external load device through the discharging control unit and the I/O interface, for example, it may charge a mobile phone or a tablet computer. Moreover, the discharging control unit may adjust a current output by the battery 1023 according to the type of the external load device to meet the requirement of the external load device.

In an exemplary embodiment, the vehicle power supply 10 may further include a positioning module (not shown), for example, a GPS module, which may be supplied with power by the battery 1023 and may communicate with the processing unit 1045. According to another embodiment, the vehicle power supply 10 may further include a communication module (not shown), for example, a WiFi or Bluetooth module, configured to communication with various networks.

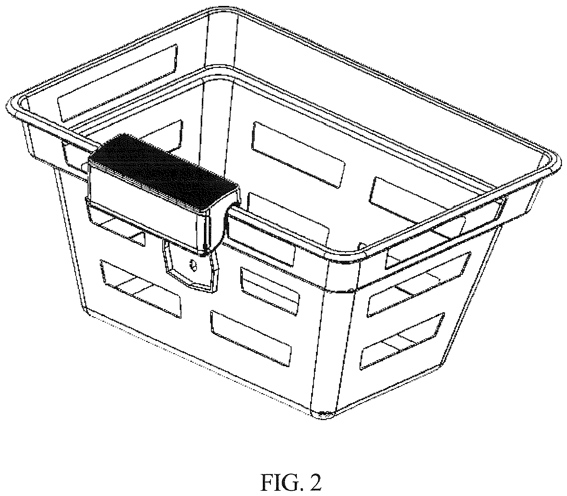

FIG. 2 is a schematic diagram of a part of a vehicle including a lighting system according to an embodiment of the present application. As shown in FIG. 2, the part of the vehicle may be a basket of a bicycle, which accommodates a housing of the lighting system. The housing may be fixed at a top edge of the basket. The solar module 1021 may be arranged at the top of the housing, and of course the solar module 1021 may be arranged at any other position of the housing. According to various demands, the vehicle lamp 12 as the light-emitting device may be one of light-emitting devices of various types, for example, a Light-Emitting Diode (LED) or the like.

In conclusion, a vehicle power supply and a vehicle lighting system include a power supplying module and a control module, the power supplying module includes a solar module, a battery charging control unit, a battery and a constant current source, which are coupled in turn; the control module coupled to the power supplying module detects light intensity of an environment where a vehicle is used through a light intensity detection unit, and detects vibration of the vehicle through a vibration detection unit, and determines whether to permit the power supplying module to supply power for a light-emitting device through a processing unit. The vehicle lighting system provided by the present application does not need charging or replacing a battery, would not cause poor user experience poor due to friction power generation, and has a good lighting effect in a weak light condition.

In addition, since the thin-film solar module is adopted, the lighting effect in the weak light environment is also good. The function of turning on/off a vehicle lamp in a more convenient intelligent automatic sensing manner is provided for a user, compared with traditional manually turning on/off a vehicle lamp of a non-motor vehicle, avoiding resource waste where lighting is still provided when the light is good, and reducing the possibility of danger occurrence due to the fact that a user forgets to turn on the vehicle lamp in a dark light environment.

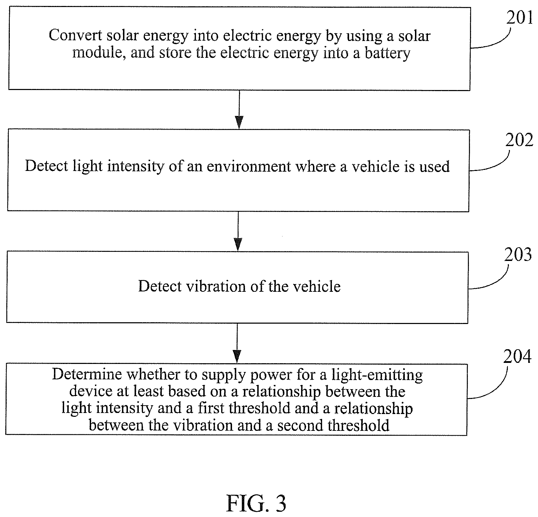

FIG. 3 is a flowchart of a method for supplying power according to an embodiment of the present application. The method shown in FIG. 3 is applied in the vehicle lighting system, including steps 201-204.

In step 201, solar energy is converted into electric energy by using a solar module, and the electric energy is stored into a battery.

In step 202, light intensity of an environment where a vehicle is used is detected.

In step 203, vibration of the vehicle is detected.

In step 204, whether to supply power for a light-emitting device is determined at least based on a relationship between the light intensity and a first threshold and a relationship between the vibration and a second threshold.

In conclusion, light intensity of an environment where the vehicle is used and the vibration of the vehicle are detected, and whether to supply power for the light-emitting device is determined at least based on the relationship between the light intensity and the first threshold and the relationship between the vibration and the second threshold. By the above method, the stability of power supplying is guaranteed, the lighting effect is good in the weak light condition, and the function of turning on/off a vehicle lamp in a more convenient intelligent automatic sensing manner is provided.

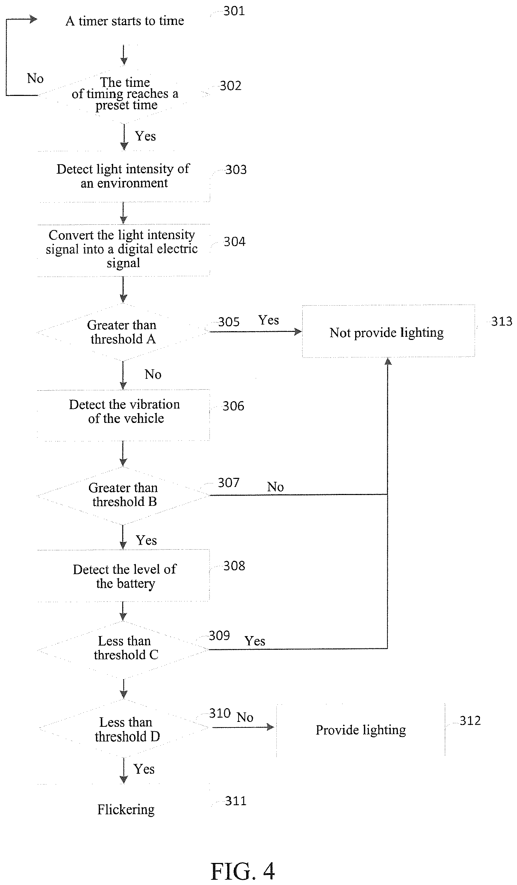

FIG. 4 is a flowchart of a method for supplying power according to another embodiment of the present application. The method shown in FIG. 4 is applied in the vehicle lighting system, including the following steps.

In step 303, a light intensity detection unit detects light intensity of an environment where a vehicle is used.

Optionally, in step 304, the detected analog light intensity signal is converted into a digital electric signal, and the digital electric signal may be a voltage signal.

In step 305, a processing unit or a comparison unit compares the detected light intensity with a first threshold (threshold A) to obtain a relationship between the detected light intensity and the first threshold. For example, the first threshold may be 151ux or other numerical value.

When the detected light intensity is greater than the first threshold, then the process jumps to the step 313, and the processing unit controls the control module not to supply power for a vehicle lamp, thereby the lighting is not provided; or a vehicle lamp is kept in an off-working state. Optionally, if the vehicle lamp is switched from the working state to the off-working state, a preset time delay may be set.

When the detected light intensity is not greater than the first threshold, then the process proceeds to the step 306, in which the vibration detection unit detects the vibration of the vehicle to determine whether the vehicle is in a use state.

In step 307, the processing unit determines whether the vibration of the vehicle is greater than a second threshold (threshold B). When the vibration detected is not greater than the second threshold, it indicates that the vehicle is not in the use state, so the process jumps to step 313, in which the processing unit controls the power supplying module not to supply power for the vehicle lamp, thereby the lighting is not provided; or the vehicle lamp is kept in an off-working state.

Optionally, when the vibration of the vehicle is greater than the second threshold, the flow may directly jump to step 312 (the jumping is not shown in figures), in which the processing unit permits the power supplying module to supply power for the vehicle lamp, thereby the lighting is provided, or the vehicle lamp is kept in a working state. Or optionally, the process proceeds to step 308, in which a battery level detection unit detects the left level of the battery.

In step 309, the processing unit determines whether the detected level of the battery is less than a third threshold (threshold C). The third threshold may be a very low level, for example, 1%, and even may be a value near 0.

When the level of the battery is less than the third threshold, the process jumps to step 313, in which the processing unit controls the power supplying module not to supply power for the vehicle lamp, thereby the lighting is not provided; or the vehicle lamp is kept in an off-working state. That is, when the battery is about to run out of power, power supplying for the light-emitting device is stopped. In addition, when the battery runs out completely, neither the control module nor the vehicle lamp will work.

When the level of the battery is not less than the third threshold, the process proceeds to step 310, in which the processing unit continues to determine whether the level of the battery is less than a fourth threshold (threshold D). In an exemplary embodiment, the fourth threshold may be a relatively low battery level, for example, 10%-30%.

When the level of the battery is not less than the fourth threshold, the process proceeds to step 312, in which the processing unit permits the power supplying module to supply power for the vehicle lamp, thereby the lighting is provided, or the vehicle lamp is kept in a working state.

When the level of the battery is less than the fourth threshold, then in step 311, the processing unit controls the power supplying module to intermittently supply power for the vehicle lamp, thereby entering a flickering light-emitting mode.

It should be noted that the order of the step related with light intensity detection, step related with vibration detection and step related with battery level detection may be changed with each other, as long as the condition of turning on the vehicle lamp is that light intensity of an environment is less than a preset threshold and vibration of the vehicle is greater than a preset threshold, that is, the vehicle is in a weak light condition and in a use state, or as long as the condition of turning on the vehicle lamp is that light intensity of an environment is less than a preset threshold, vibration of the vehicle is greater than a preset threshold and the level of the battery is greater than a preset level.

Optionally, before starting the above detection steps, the method may further include steps 301-302.

In step 301, a timer starts to time.

In step 302, it is determined whether the time of timing reaches a threshold, if not, the process jumps to the step 301 to continue timing; if yes, the process proceeds to the step 303. Optionally, the threshold of the time of timing may be 5 seconds. Optionally, when continuous multiple light intensity detection results are all greater than a preset light intensity level, it means that the environment where the vehicle is used is daytime, and the time interval of the timing may be adjusted accordingly to a greater numerical value.

In conclusion, the light intensity of an environment where the vehicle is used and the vibration of the vehicle are detected, and whether the light intensity is greater than the first threshold is determined. When the light intensity is greater than the first threshold, it is determined that power is not supplied. When the light intensity is not greater than the first threshold, whether the vibration is greater than the second threshold is determined. When the vibration is not greater than the second threshold, it is determined that power is not supplied. When the vibration is greater than the second threshold, it is determined that power is supplied. After it is determined that power is supplied, the level of the battery is detected. When the level of the battery is less than the third threshold, power supplying is stopped. When the level of the battery is not less than the third threshold, whether the level of the battery is less than the fourth threshold is determined. When the level of the battery is not less than the fourth threshold, power is supplied continuously and the light-emitting mode is a continuous light-emitting mode. When the level of the battery is less than the fourth threshold, power is supplied intermittently to enter a flickering light-emitting mode. With the present application, the stability of power supplying is ensured, multiple light-emitting modes are provided, and the function of turning on/off a vehicle lamp in a more convenient intelligent automatic sensing manner is supplied.

With the vehicle lighting system provided by embodiments of the present application, it is not needed to charge or replace a battery, and the user experience would not be affected like the vehicle with friction power generation. In addition, since the thin-film solar module is adopted, the lighting effect in the weak light environment is also good. The function of turning on/off a vehicle lamp in a more convenient intelligent automatic sensing manner is provided for a user, compared with traditional manually turning on/off a vehicle lamp of a non-motor vehicle, avoiding resource waste where lighting is still provided when the light is good, and further reducing the possibility of danger occurrence due to the fact that a user forgets to turn on the vehicle lamp in a dark light environment. It is more accurate to determine the use state of the vehicle through the vibration detection unit than through determining whether the vehicle is unlocked, and this is also suitable for the motor vehicle in situations where a vehicle lock is not provided, the user forgets to lock the vehicle or the vehicle lock is broken.

With the vehicle power supply, vehicle lighting system and method for supplying power provided in the embodiments, travel resistance will not be increased, the abrasion of the tire is avoided, the stability of light-emitting of the vehicle lamp is ensured, and a function of turning on/off the vehicle lamp in a more convenient intelligent automatic sensing manner is provided.

The above embodiments are used just for explanation of the present application, but not intended to limit the present application. For those of ordinary skill in the related art, various changes and variants may be made without departing from the protection scope of the present application, therefore all equivalent technical solutions should fall within the disclosure scope of the present application.

## Claims

1. A vehicle power supply (10), comprising a power supplying module (102) and a control module (104) coupled to the power supplying module (102), wherein,
the power supplying module (102) comprises a solar module (1021), a battery charging control unit (1022), a battery (1023) and a constant current source (1024) coupled in turn; and
the control module (104) comprises:
a light intensity detection unit (1041), configured to detect light intensity of an environment where a vehicle is used;
a vibration detection unit (1043), configured to detect vibration of the vehicle; and
a processing unit (1045), configured to determine whether to permit the power supplying module (102) to supply power for a light-emitting device at least based on a relationship between the light intensity detected by the light intensity detection unit (1041) and a first threshold and a relationship between the vibration detected by the vibration detection unit (1043) and a second threshold.

2. The vehicle power supply (10) according to claim 1, wherein the control module (104) further comprises: a battery level detection unit (1044), configured to detect a level of the battery (1023); and
the processing unit (1045) is further configured to determine whether to permit the power supplying module (102) to supply power for the light-emitting device at least based on a relationship between a detection result of the battery level detection unit (1044) and a third threshold, the relationship between the light intensity detected by the light intensity detection unit (1041) and the first threshold and the relationship between the vibration detected by the vibration detection unit (1043) and the second threshold.

3. The vehicle power supply (10) according to claim 2, wherein the processing unit (1045) is further configured to determine a light-emitting mode of the light-emitting device according to a relationship between the level of the battery (1023) and a fourth threshold.

4. The vehicle power supply (10) according to claim 2, wherein the control module (104) further comprises a comparison unit (1042) coupled between the light intensity detection unit (1041) and the processing unit (1045).

5. The vehicle power supply (10) according to any one of claims 1-4, wherein the solar module (1021) comprises a thin-film solar module.

6. The vehicle power supply (10) according to any one of claims 1-4, wherein the vehicle power supply (10) further comprises a positioning module respectively coupled to the power supplying module (102) and the control module (104), and the positioning module at least comprises a Global Position System positioning module; or
the vehicle power supply (10) further comprises a communication module respectively coupled to the power supplying module (102) and the control module (104), and the communication module at least comprises a WiFi module and/or a Bluetooth module.

7. The vehicle power supply (10) according to any one of claims 1-4, wherein the vehicle power supply (10) further comprises a discharging module coupled to the battery (1023) and the processing unit (1045), and the discharging module comprises a discharging control unit and an I/O interface coupled with the discharging control unit; the discharging control unit is configured to permit the battery (1023) to supply power for a load device through the I/O interface under control of the processing unit (1045).

8. The vehicle power supply (10) according to claim 7, wherein the discharging control unit is further configured to adjust a current output by the battery (1023) according to a type of the load device.

9. A vehicle lighting system comprising:
a light-emitting device; and
the vehicle power supply (10) according to any one of claims 1-8 coupled to the light-emitting device.

10. A method for supplying power for a vehicle lighting system, comprising:
converting solar energy into electric energy by using a solar module, and storing the electric energy into a battery (201);
detecting light intensity of an environment where a vehicle is used (202);
detecting vibration of the vehicle (203);
determining whether to supply power for a light-emitting device at least based on a relationship between the light intensity and a first threshold and a relationship between the vibration and a second threshold (204).

11. The method according to claim 10, further comprising:
detecting a level of the battery;
determining whether to supply power for the light-emitting device at least based on a relationship between the level of the battery and a third threshold, the relationship between the light intensity and the first threshold and the relationship between the vibration and the second threshold.

12. The method according to claim 10 or 11, further comprising:
determining a light-emitting mode of the light-emitting device according to a relationship between the level of the battery and a fourth threshold.

13. The method according to claim 10, wherein determining whether to supply power for a light-emitting device at least based on a relationship between the light intensity and a first threshold and a relationship between the vibration and a second threshold (204) comprises:
determining whether the light intensity is greater than the first threshold;
when the light intensity is greater than the first threshold, determining not to supply power for the light-emitting device;
when the light intensity is not greater than the first threshold, determining whether the vibration is greater than the second threshold;
when the vibration is not greater than the second threshold, determining not to supply power;
when the vibration is greater than the second threshold, determining to supply power.

14. The method according to claim 11 or 12, further comprising:
when the level of the battery is less than the third threshold, stopping supplying power;
when the level of the battery is not less than the third threshold, determining whether the level of the battery is less than a fourth threshold;
when the level of the battery is not less than the fourth threshold, supplying power continuously and determining the light-emitting mode of the light-emitting device to be a continuous light-emitting mode;
when the level of the battery is less than the fourth threshold, supplying power intermittently and determining the light-emitting mode of the light-emitting device to be a flickering light-emitting mode.

15. The method according to claim 12, wherein the light-emitting mode comprises a continuous light-emitting mode and a flickering light-emitting mode.
